# EUROPEAN PATENT APPLICATION

(11) **EP 4 827 272 A1**
(43) Date of publication of application: **21.10.2026**
(21) Application number: 24910678.2
(22) Date of filing: 10.12.2024
(51) Int. Cl.: H10D 62/81, H01S 5/34

(54) **LED, OPTICAL COMMUNICATION DEVICE, AND OPTICAL COMMUNICATION SYSTEM**

(30) Priority: 26.12.2023 CN 202311818917
(71) Applicant: Huawei Technologies Co., Ltd., Shenzhen, Guangdong 518129 (CN)
(72) Inventor: LU, Shiqiang, Shenzhen, Guangdong 518129 (CN); PENG, Liyuan, Shenzhen, Guangdong 518129 (CN); QIU, Botong, Shenzhen, Guangdong 518129 (CN); HE, Jifang, Shenzhen, Guangdong 518129 (CN)
(74) Representative: Huawei European IPR
(86) International application number: PCT/CN2024/137983
(87) International publication number: WO 2025/139747

(57) **Abstract**

This application provides an LED, used in the LED field or the optical communication field. The LED includes a P-type semiconductor layer, an active layer, and an N-type semiconductor layer. The active layer is located between the P-type semiconductor layer and the N-type semiconductor layer. The active layer includes M barrier layers and M-1 well layers. The barrier layers and the well layers are alternately distributed. M is an integer greater than 1. Each of the M barrier layers is a P-type doped layer. A sum of doping concentrations of N first barrier layers that are among the M barrier layers and that are close to the N-type semiconductor layer is greater than a sum of doping concentrations of N second barrier layers that are among the M barrier layers and that are close to the P-type semiconductor layer. When M is an even number, N=M/2; or when M is an odd number, N=M/2-1/2. In the technical solutions provided in this application, P-type doping concentrations of the M barrier layers are controlled, so that bandwidth of the LED can be increased, thereby improving optical communication efficiency.

## Description

This application claims priority to Chinese Patent Application No. 202311818917.8, filed with the China National Intellectual Property Administration on December 26, 2023 and entitled "LED, OPTICAL COMMUNICATION APPARATUS, AND OPTICAL COMMUNICATION SYSTEM", which is incorporated herein by reference in its entirety.

### TECHNICAL FIELD

This application relates to the LED field or the optical communication field, and in particular, to a light emitting diode (light emitting diode, LED), an LED array, an optical communication apparatus, and an optical communication system.

### BACKGROUND

In short-distance data communication, electrical interconnection is generally employed. For example, copper cables are used for short-distance interconnection within 10 meters in data centers, metal traces are used for on-board communication on PCB boards, and metallic interconnections are likewise used for interconnection between chips. With the rapid development of technologies such as the internet, cloud computing, edge computing, and artificial intelligence (Artificial intelligence, AI), the required communication bandwidth for short-distance scenarios such as interconnection within 10 meters in the data centers, interconnection on PCB boards, and interconnection between chips has increased sharply. Compared with electrical interconnection, optical interconnection has absolute advantages in terms of performance such as data rate and transmission distance. Replacing electrical interconnection with optical interconnection has become a mainstream trend in short-distance communication scenarios. In optical interconnection, lasers are generally used as a light source of a transmitter. However, the lasers suffer from problems of high threshold currents, high power consumption, poor operation performance at high temperature, high costs, and the like. Using micro-LEDs as a light source is conducive to implementing optical communication systems that feature low power consumption, low costs, wide temperature operation, and high reliability. However, the low bandwidth of micro-LEDs limits the efficiency of optical communication.

### SUMMARY

This application provides an LED, an LED array, an optical communication apparatus, and an optical communication system. P-type doping concentrations of M barrier layers are controlled, so that bandwidth of the LED can be increased, thereby improving optical communication efficiency.

A first aspect of this application provides an LED. The LED includes a P-type semiconductor layer, an active layer, and an N-type semiconductor layer. The active layer is located between the P-type semiconductor layer and the N-type semiconductor layer. The active layer includes M barrier layers and M-1 well layers. The barrier layers and the well layers are alternately distributed. M is an integer greater than 1. Each of the M barrier layers is a P-type doped layer. A sum of doping concentrations of N first barrier layers that are among the M barrier layers and that are close to the N-type semiconductor layer is greater than a sum of doping concentrations of N second barrier layers that are among the M barrier layers and that are close to the P-type semiconductor layer. When M is an even number, N=M/2; or when M is an odd number, N=M/2-1/2.

In this application, P-type doping is performed on each barrier layer, so that a quantity of carriers in the active layer can be increased. In addition, distribution of P-type doping concentrations of the M barrier layers is controlled. This helps improve carrier distribution uniformity in an active region and carrier transmission in a multi-quantum well, thereby increasing a bandwidth of the LED.

In an optional manner of the first aspect, a P-type edge barrier layer is a barrier layer that is among the M barrier layers and that is closest to the P-type semiconductor layer. An N-type edge barrier layer is a barrier layer that is among the M barrier layers and that is closest to the N-type semiconductor layer. A target barrier layer is a non-edge barrier layer among the M barrier layers. Doping concentrations of barrier layers gradually increase from the N-type edge barrier layer to the target barrier layer. Doping concentrations of barrier layers gradually decrease from the target barrier layer to the P-type edge barrier layer. Such doping concentration distribution design helps improve carrier distribution uniformity in an active region, thereby enhancing concentration matching between electrons and holes and increasing a bandwidth of the LED.

In an optional manner of the first aspect, M is equal to 6, in a direction from the N-type semiconductor layer to the P-type semiconductor layer, doping concentrations of the M barrier layers are respectively C1, C2, C3, C4, C5, and C6, and C1<C2>C3>C4>C5>C6.

In an optional manner of the first aspect, in a direction from the N-type semiconductor layer to the P-type semiconductor layer, doping concentrations of the M barrier layers gradually decrease. Such doping concentration distribution design can supplement a hole concentration in a quantum well close to the N-type semiconductor layer and increase a bandwidth of the LED.

In an optional manner of the first aspect, M is equal to 6, in the direction from the N-type semiconductor layer to the P-type semiconductor layer, the doping concentrations of the M barrier layers are respectively C1, C2, C3, C4, C5, and C6, and C1>C2>C3>C4>C5>C6.

In an optional manner of the first aspect, doping concentrations of X barrier layers that are among the M barrier layers and that are close to the N-type semiconductor layer are the same. Doping concentrations of Y barrier layers that are among the M barrier layers and that are close to the P-type semiconductor layer are the same. A doping concentration of each of the X barrier layers is greater than a doping concentration of each of the Y barrier layers. M is equal to a sum of X and Y. Such doping concentration distribution design can reduce difficulty of LED epitaxy and increase a bandwidth of the LED.

In an optional manner of the first aspect, M is equal to 6, in a direction from the N-type semiconductor layer to the P-type semiconductor layer, doping concentrations of the M barrier layers are respectively C1, C2, C3, C4, C5, and C6, and C1=C2=C3>C4=C5=C6.

In an optional manner of the first aspect, doping concentrations of X barrier layers that are among the M barrier layers and that are close to the N-type semiconductor layer are the same. Doping concentrations of Y barrier layers that are among the M barrier layers and that are close to the P-type semiconductor layer are the same. Doping concentrations of Z barrier layers among the M barrier layers other than the X barrier layers and the Y barrier layers are the same. The doping concentrations of the Z barrier layers among the M barrier layers are the same. The doping concentrations of the X barrier layers are greater than the doping concentrations of the Z barrier layers. The doping concentrations of the Z barrier layers are greater than the doping concentrations of the Y barrier layers. M is equal to a sum of X, Y, and Z. Such doping concentration distribution design can reduce difficulty of epitaxial control of the LED.

In an optional manner of the first aspect, M is equal to 6, in a direction from the N-type semiconductor layer to the P-type semiconductor layer, doping concentrations of the M barrier layers are respectively C1, C2, C3, C4, C5, and C6, and C1=C2>C3=C4>C5=C6.

In an optional manner of the first aspect, a highest doping concentration among the doping concentrations of the M barrier layers ranges from 1 × 10¹⁸ to 1 × 10²¹ per cubic centimeter, and a lowest doping concentration among the doping concentrations of the M barrier layers ranges from 1 × 10¹⁶ to 1 × 10¹⁸ per cubic centimeter.

In an optional manner of the first aspect, a sum of thicknesses of K first barrier layers and K first well layers that are among the M barrier layers and the M-1 well layers and that are close to the N-type semiconductor is greater than a sum of thicknesses of K second barrier layers and K second well layers that are close to the P-type semiconductor. When M is an even number, K=M/2-1. When M is an odd number, K=M/2-1/2. The thicknesses of the barrier layer and the well layer close to the P side are less than the thicknesses of the barrier layer and the well layer close to the N-type semiconductor layer. This helps improve a density of carriers in a quantum well close to the P side, and also helps improve transport characteristics of carriers in a multi-quantum well, especially injection and transport of hole carriers, thereby increasing a bandwidth of the LED.

In an optional manner of the first aspect, thicknesses of the M-1 well layers are the same, and thicknesses of the M barrier layers are different.

In an optional manner of the first aspect, the thicknesses of the K first barrier layers are the same. The thicknesses of the K second barrier layers are the same, and the thickness of the first barrier layer is greater than the thickness of the second barrier layer.

In an optional manner of the first aspect, the M barrier layers include X first barrier layers and Y second barrier layers, M is equal to a sum of X and Y, thicknesses of the X first barrier layers are the same, thicknesses of the Y second barrier layers are the same, and the thickness of the first barrier layer is greater than the thickness of the second barrier layer.

In an optional manner of the first aspect, thicknesses of the M barrier layers are the same, and thicknesses of the M-1 well layers are different.

In an optional manner of the first aspect, the thicknesses of the K first well layers are the same, the thicknesses of the K second well layers are the same, and the thickness of the first well layer is greater than the thickness of the second well layer.

In an optional manner of the first aspect, the M-1 well layers include X-1 first well layers and Y second well layers, M is equal to a sum of X and Y, thicknesses of the X-1 first well layers are the same, thicknesses of the Y second well layers are the same, and the thickness of the first well layer is greater than the thickness of the second well layer.

In an optional manner of the first aspect, thicknesses of the M barrier layers are different, and thicknesses of the M-1 well layers are different.

In an optional manner of the first aspect, the M barrier layers include X first barrier layers and Y second barrier layers, M is equal to a sum of X and Y, thicknesses of the X first barrier layers are the same, thicknesses of the Y second barrier layers are the same, and the thickness of the first barrier layer is greater than the thickness of the second barrier layer.

In an optional manner of the first aspect, the M-1 well layers include X-1 first well layers and Y second well layers, M is equal to a sum of X and Y, thicknesses of the X-1 first well layers are the same, thicknesses of the Y second well layers are the same, and the thickness of the first well layer is greater than the thickness of the second well layer.

A second aspect of this application provides an LED array. The LED array includes another LED and the LED according to any one of the first aspect or the optional manners of the first aspect, where the another LED and the LED share a same substrate.

A third aspect of this application provides an optical communication apparatus. The optical communication apparatus includes the LED according to any one of the first aspect or the optional manners of the first aspect or the LED array according to the second aspect. The optical communication apparatus further includes a processing circuit. The processing circuit is configured to transmit an electrical signal to the LED or the LED array. The LED or the LED array is configured to generate an optical signal based on the electrical signal.

In an optional manner of the third aspect, the optical communication apparatus further includes an optical coupling structure, where the optical coupling structure is configured to reduce a divergence angle of the LED or the LED in the LED array.

In an optional manner of the third aspect, the optical communication apparatus further includes a photodetector (photodetector, PD). The PD or a PD array is configured to receive another optical signal, and convert the another optical signal into another electrical signal; and the processing circuit is configured to receive the another electrical signal.

In an optional manner of the third aspect, the optical communication apparatus further includes another optical coupling structure, where the another optical coupling structure is configured to focus the another optical signal. The PD or the PD array is configured to convert the another focused optical signal into the another electrical signal.

A fourth aspect of this application provides an optical communication system. The optical communication system includes another optical communication apparatus and the optical communication apparatus according to any one of the third aspect or the optional manners of the third aspect. The optical communication apparatus is connected to the another optical communication apparatus through an optical fiber or an optical waveguide. The optical communication apparatus is configured to transmit the optical signal to the another optical communication apparatus.

### BRIEF DESCRIPTION OF DRAWINGS

FIG. 1a is a diagram of a first structure of an LED according to an embodiment of this application;
FIG. 1b is a diagram of a second structure of an LED according to an embodiment of this application;
FIG. 2 is a diagram of a relationship between a bandwidth of an LED and an injection current density at different P-type doping concentrations, where the relationship is calculated according to an LED bandwidth formula;
FIG. 3a is a distribution diagram of electron concentrations in a multi-quantum well active region;
FIG. 3b is a distribution diagram of hole carrier concentrations in a multi-quantum well active region;
FIG. 4 is a diagram of a third structure of an LED according to an embodiment of this application;
FIG. 5 is a simulation diagram of a bandwidth of an LED with an undoped barrier layer in an active region according to an embodiment of this application;
FIG. 6 is a simulation diagram of a bandwidth of an LED undergone doping in a first example according to an embodiment of this application;
FIG. 7 is a simulation diagram of a bandwidth of an LED undergone doping in a second example according to an embodiment of this application;
FIG. 8 is a simulation diagram of a bandwidth of an LED undergone doping in a third example according to an embodiment of this application;
FIG. 9a is a diagram of a fourth structure of an LED according to an embodiment of this application;
FIG. 9b is a diagram of a fifth structure of an LED according to an embodiment of this application;
FIG. 9c is a diagram of a sixth structure of an LED according to an embodiment of this application;
FIG. 9d is a diagram of a seventh structure of an LED according to an embodiment of this application;
FIG. 9e is a diagram of an eighth structure of an LED according to an embodiment of this application;
FIG. 9f is a diagram of a ninth structure of an LED according to an embodiment of this application;
FIG. 9g is a diagram of a tenth structure of an LED according to an embodiment of this application;
FIG. 10 is a diagram of a structure of an epitaxial wafer according to an embodiment of this application;
FIG. 11 is a diagram of an eleventh structure of an LED according to an embodiment of this application;
FIG. 12 is a diagram of a structure of an LED array according to an embodiment of this application;
FIG. 13 is a diagram of a first structure of an optical communication apparatus according to an embodiment of this application;
FIG. 14 is a diagram of a second structure of an optical communication apparatus according to an embodiment of this application;
FIG. 15 is a diagram of a third structure of an optical communication apparatus according to an embodiment of this application;
FIG. 16 is a diagram of a fourth structure of an optical communication apparatus according to an embodiment of this application;
FIG. 17 is a diagram of a fifth structure of an optical communication apparatus according to an embodiment of this application; and
FIG. 18 is a diagram of a structure of an optical communication system according to an embodiment of this application.

### DESCRIPTION OF EMBODIMENTS

This application provides an LED, an LED array, an optical communication apparatus, and an optical communication system. P-type doping concentrations of M barrier layers are controlled, so that bandwidth of the LED can be increased, thereby improving optical communication efficiency. It should be understood that "first", "second", "target", and the like used in this application are merely used for distinguishing and description, but should not be understood as an indication or implication of relative importance or an indication or implication of a sequence. In addition, for brevity and clarity, reference numbers and/or letters are repeated in a plurality of accompanying drawings of this application. Repetition is not indicative of a strict limiting relationship between various embodiments and/or configurations.

The LED provided in this application is used in the LED field and/or the optical communication field. In the optical communication field, electrical interconnection is generally used for short-distance data communication. Compared with the electrical interconnection, optical interconnection has absolute advantages in terms of performance such as a rate and a transmission distance. Replacing the electrical interconnection with the optical interconnection has become a mainstream trend in short-distance communication scenarios. In the optical interconnection, a laser is generally used as a light source of a transmitter. The laser has the following problems: high threshold currents, high power consumption, poor operation performance at a high temperature, high costs, and the like. Using a micro-LED as a light source is conducive to implementing an optical communication system that features low power consumption, low costs, wide temperature operation, and high reliability. However, a bandwidth of the micro-LED is low, resulting in reduction of optical communication efficiency.

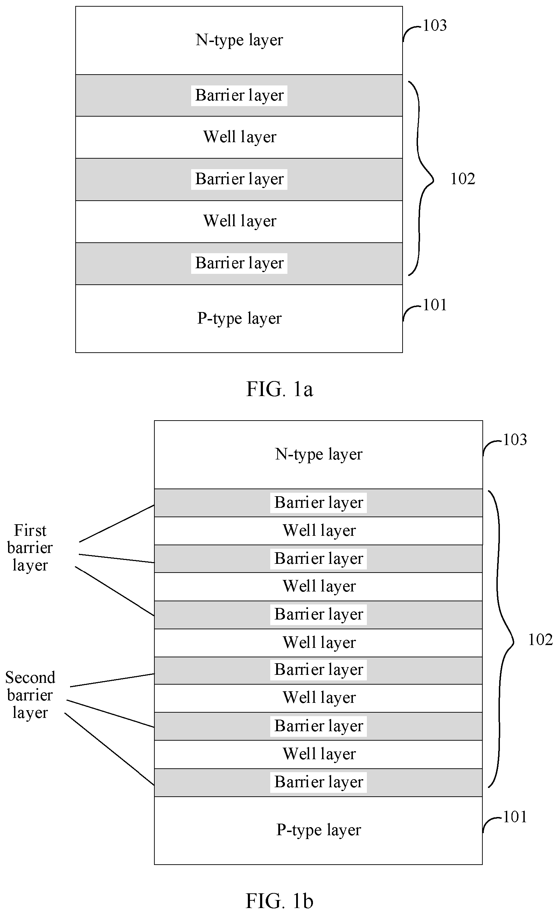

Therefore, this application provides an LED. FIG. 1a is a diagram of a first structure of an LED according to an embodiment of this application. As shown in FIG. 1a, the LED includes a P-type semiconductor layer 101, an active layer 102, and an N-type semiconductor layer 103. The P-type semiconductor layer 101 is also referred to as a P-type layer 101. The N-type semiconductor layer 103 is also referred to as an N-type layer 103. The active layer 102 is located between the P-type semiconductor layer 101 and the N-type semiconductor layer 103. The active layer 102 includes M barrier layers and M-1 well layers. The barrier layers and the well layers are alternately distributed. M is an integer greater than 1. In an example of FIG. 1a, the active layer 102 includes three barrier layers and two well layers. Each of the M barrier layers is a P-type doped layer. A dopant of the P-type doped layer may be magnesium Mg. A sum of doping concentrations of N first barrier layers that are among the M barrier layers and that are close to the N-type semiconductor layer 103 is greater than a sum of doping concentrations of N second barrier layers that are among the M barrier layers and that are close to the P-type semiconductor layer 101. When M is an even number, N=M/2; or when M is an odd number, N=M/2-1/2. FIG. 1b is a diagram of a second structure of an LED according to an embodiment of this application. As shown in FIG. 1b, when M is equal to 6, the M barrier layers include three first barrier layers and three second barrier layers.

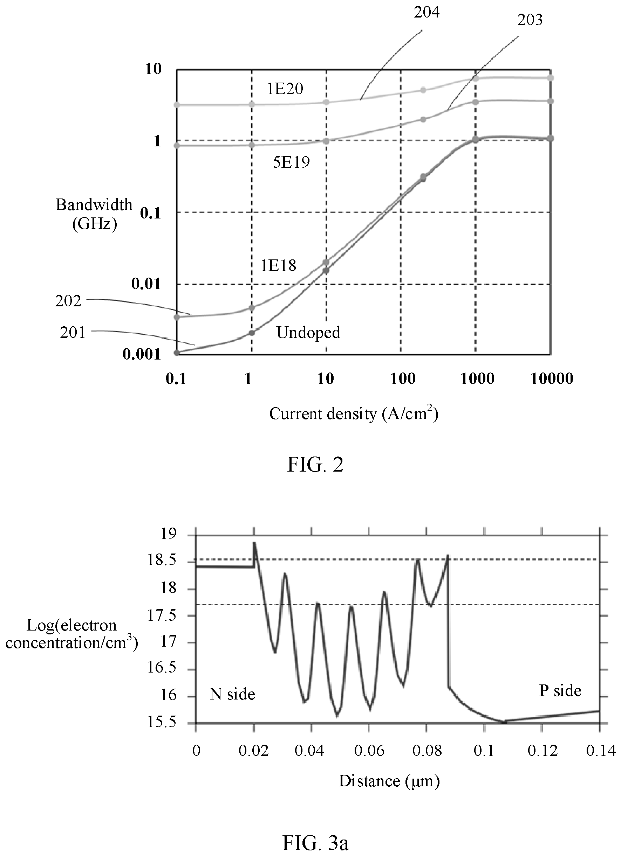

Based on an ABC model of LED recombination, inner quantum efficiency of the LED may be expressed as: $IQE = \frac{Bn}{A + Bn + {Cn}^{2}} .$ IQE is the inner quantum efficiency of the LED, A is a defect-related Shockley-Read-Hall (SRH) recombination coefficient, B is a radiative recombination coefficient, C is an Auger recombination coefficient, and n is a carrier density. A differential carrier lifetime τ of the LED is: $τ = \frac{1}{A + 2 Bn + 3 {Cn}^{2}} .$ A bandwidth *f*_{3*dB*} of the LED is inversely proportional to the carrier lifetime, that is, ${τ}^{- 1} = 2 {πf}_{3 dB} = A + 2 Bn + 3 {Cn}^{2} .$ It can be learned from the foregoing formula that, the bandwidth of the LED can be increased by increasing the SRH recombination coefficient A, the radiative recombination coefficient B, the Auger recombination coefficient C, and the carrier density n. In addition, as the injection current density n increases, the bandwidth of the LED also increases. During operation at a low current, the current density n of an active region of the LED is excessively low, resulting in a limited bandwidth of the LED operating at the low current. To increase the bandwidth of the LED operating at the low current, the active region of the LED may be doped to provide a background carrier and increase a value of n. For a gallium nitride GaN-based LED, in a device, a hole concentration is far lower than an electron concentration due to difficulty of P-type doping and high P-type activation energy. Therefore, P-type doping may be preferred for doping in a quantum well. FIG. 2 is a diagram of a relationship between a bandwidth of an LED and an injection current density at different P-type doping concentrations of barrier layers, where the relationship is calculated according to an LED bandwidth formula. A horizontal coordinate in FIG. 2 represents a current density in a unit of amperes per square centimeter A/cm². A vertical coordinate in FIG. 2 represents a bandwidth in a unit of gigahertz GHz. When a quantum well barrier layer is undoped, the relationship between the bandwidth of the LED and the injection current density is a curve 201. When a P-type doping concentration of a quantum well barrier layer is 1 × 10¹⁸ per cubic centimeter, the relationship between the bandwidth of the LED and the injection current density is a curve 202. When a P-type doping concentration of a quantum well barrier layer is 5 × 10¹⁹ per cubic centimeter, the relationship between the bandwidth of the LED and the injection current density is a curve 203. When a P-type doping concentration of a quantum well barrier layer is 1 × 10²⁰ per cubic centimeter, the relationship between the bandwidth of the LED and the injection current density is a curve 204. It can be learned from FIG. 2 that, P-type doping is performed on the quantum well barrier layer, so that the bandwidth of the LED can be effectively increased, especially at a low current. When the P-type doping concentration reaches 10¹⁹ per cubic centimeter, the bandwidth of the LED is significantly improved at a low current density, and may reach 1 GHz. In a case of a high current, the bandwidth of the LED may reach 3 GHz.

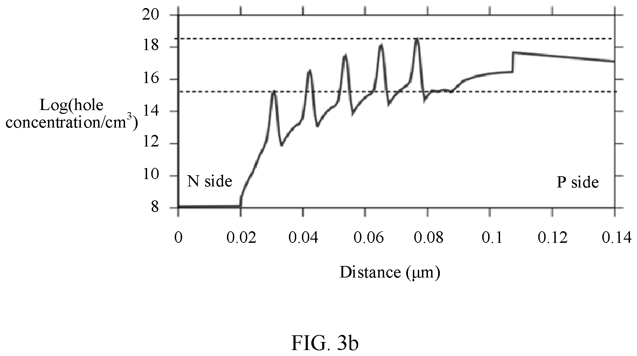

In addition, there are problems of carrier mismatch and non-uniform carrier distribution in the GaN-based LED. FIG. 3a is a distribution diagram of electron concentrations in a multi-quantum well active region. FIG. 3b is a distribution diagram of hole carrier concentrations in a multi-quantum well active region. Horizontal coordinates in FIG. 3a and FIG. 3b represent distances from the N-type layer 103. Vertical coordinates in FIG. 3a and FIG. 3b represent logarithmic values of the electron concentration and the hole concentration. The logarithmic values are in units of Log(electron concentration/cm³) and Log(hole concentration/cm³). As shown in FIG. 3a and FIG. 3b, during low current injection at 500 A/cm², because P-type doping efficiency of GaN is much lower than N-type doping efficiency of GaN, and hole mobility is lower than electron mobility, a concentration (on the order of 10¹⁵-10¹⁸) of holes injected into the quantum well is one to two orders of magnitude lower than a concentration (on the order of 10^{17.5}-10^{18.5}) of electrons. As shown in FIG. 3a and FIG. 3b, electrons are distributed more uniformly in the multi-quantum well. In comparison with electron distribution, holes are distributed more non-uniformly in the multi-quantum well. In addition, hole distribution is clearly characterized by a low hole concentration in the N-side quantum well and a high hole concentration in the P-side quantum well. Therefore, in this embodiment of this application, a P-type doping concentration of a region close to the N-type semiconductor layer is higher than a P-type doping concentration of a region close to the P side. Distribution of the P-type doping concentrations is controlled, so that a hole concentration close to the N-side quantum well can be supplemented, to achieve more uniform carrier distribution and better match between electron and hole concentrations, and increase the bandwidth of the LED.

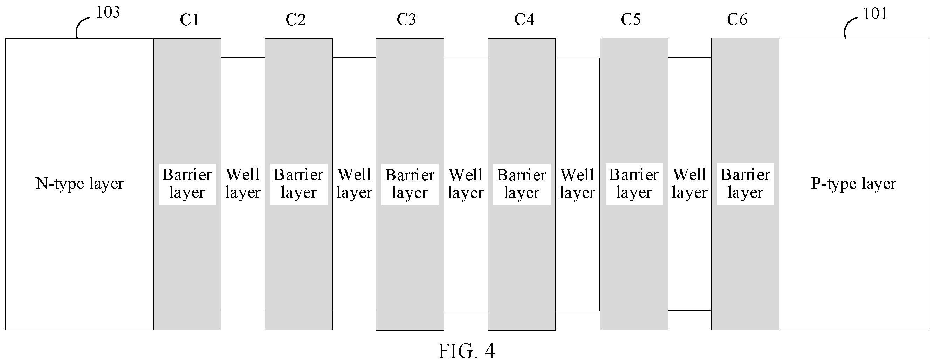

It can be learned from the foregoing descriptions of FIG. 1a that, the sum of the doping concentrations of the N first barrier layers that are among the M barrier layers and that are close to the N-type semiconductor layer 103 is greater than the sum of the doping concentrations of the N second barrier layers that are among the M barrier layers and that are close to the P-type semiconductor layer 101. The following uses an example in which M is equal to 6 for description. FIG. 4 is a diagram of a third structure of an LED according to an embodiment of this application. As shown in FIG. 4, the LED includes an N-type layer 103, a P-type layer 101, and an active layer located between the N-type layer 103 and the P-type layer 101. The active layer includes six barrier layers. Doping concentrations of the six barrier layers are respectively C1, C2, C3, C4, C5, and C6. C1+C2+C3>C4+C5+C6. This application provides several different doping concentration distribution designs. The following separately describes the designs by using an example in which M is equal to 6.

In a first example, a P-type edge barrier layer is a barrier layer that is among the M barrier layers and that is closest to the P-type semiconductor layer. An N-type edge barrier layer is a barrier layer that is among the M barrier layers and that is closest to the N-type semiconductor layer. A target barrier layer is a non-edge barrier layer among the M barrier layers. Doping concentrations of barrier layers gradually increase from the N-type edge barrier layer to the target barrier layer. Doping concentrations of barrier layers gradually decrease from the target barrier layer to the P-type edge barrier layer. For example, when a value of C3 is the largest among doping concentrations of the M barrier layers, C1<C2<C3>C4>C5>C6. When a value of C2 is the largest among the doping concentrations of the M barrier layers, C1<C2>C3>C4>C5>C6. For example, the doping concentration C1 ranges from 4.5 × 10¹⁹ to 5.5 × 10¹⁹ per cubic centimeter; the doping concentration C2 ranges from 0.5 × 10²⁰ to 1.5 × 10²⁰ per cubic centimeter; the doping concentration C3 ranges from 4.5 × 10¹⁹ to 5.5 × 10¹⁹ per cubic centimeter; the doping concentration C4 ranges from 0.5 × 10¹⁹ to 1.5 × 10¹⁹ per cubic centimeter; the doping concentration C5 ranges from 4.5 × 10¹⁸ to 5.5 × 10¹⁸ per cubic centimeter; and the doping concentration C6 ranges from 0.5 × 10¹⁸ to 1.5 × 10¹⁸ per cubic centimeter.

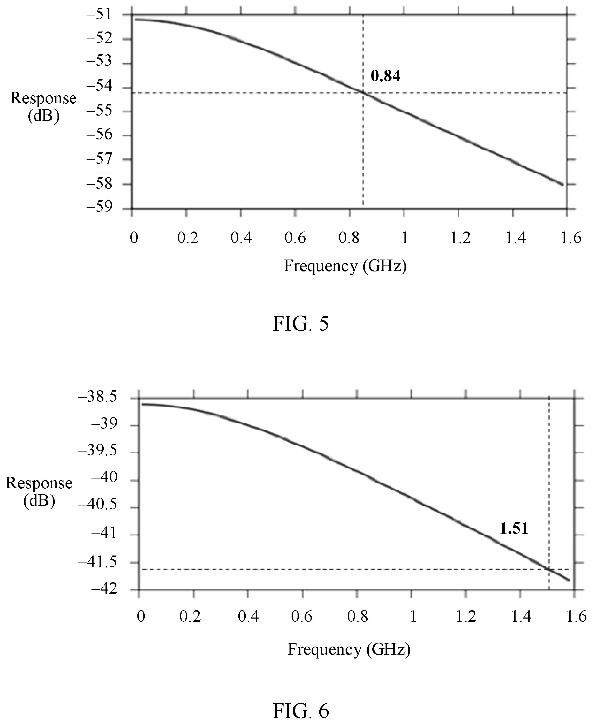

FIG. 5 is a simulation diagram of a bandwidth of an LED with an undoped barrier layer in an active region according to an embodiment of this application. A horizontal coordinate in FIG. 5 represents a bandwidth in a unit of GHz. A vertical coordinate in FIG. 5 represents a responsivity in a unit of dB. As shown in FIG. 5, at a low current density of 500 A/cm², a 3 dB modulation bandwidth of the LED with the undoped barrier layer is only 0.84 GHz. FIG. 6 is a simulation diagram of a bandwidth of an LED undergone doping in a first example according to an embodiment of this application. As shown in FIG. 6, at a low current density of 500 A/cm², a 3 dB modulation bandwidth of the LED undergone doping in the first example is 1.51 GHz. Compared with the modulation bandwidth of the LED in FIG. 5, this modulation bandwidth is increased by 0.67 GHz.

In a second example, in a direction from the N-type semiconductor layer 103 to the P-type semiconductor layer 101, doping concentrations of the M barrier layers gradually decrease. In this case, C1>C2>C3>C4>C5>C6. For example, the doping concentration C1 ranges from 4.5 × 10²⁰ to 5.5 × 10²⁰ per cubic centimeter; the doping concentration C2 ranges from 0.5 × 10²⁰ to 1.5 × 10²⁰ per cubic centimeter; the doping concentration C3 ranges from 4.5 × 10¹⁹ to 5.5 × 10¹⁹ per cubic centimeter; the doping concentration C4 ranges from 0.5 × 10¹⁹ to 1.5 × 10¹⁹ per cubic centimeter; the doping concentration C5 ranges from 4.5 × 10¹⁸ to 5.5 × 10¹⁸ per cubic centimeter; and the doping concentration C6 ranges from 0.5 × 10¹⁸ to 1.5 × 10¹⁸ per cubic centimeter.

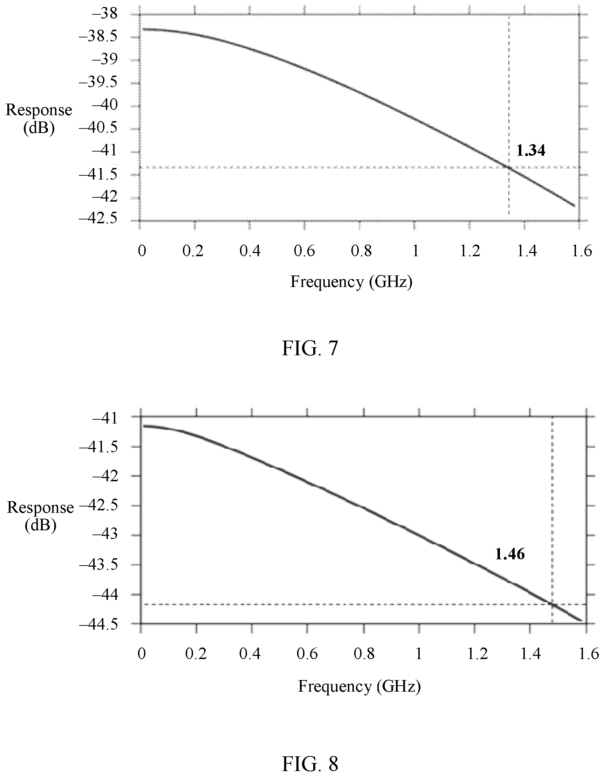

FIG. 7 is a simulation diagram of a bandwidth of an LED undergoing doping in a second example according to an embodiment of this application. As shown in FIG. 7, at a low current density of 500 A/cm², a 3 dB modulation bandwidth of the LED undergoing doping in the second example is 1.34 GHz. Compared with the modulation bandwidth of the LED in FIG. 5, this modulation bandwidth is increased by 0.5 GHz.

In a third example, doping concentrations of X barrier layers that are among the M barrier layers and that are close to the N-type semiconductor layer 103 are the same. Doping concentrations of Y barrier layers that are among the M barrier layers and that are close to the P-type semiconductor layer 101 are the same. The doping concentrations of the X barrier layers are greater than the doping concentrations of the Y barrier layers. M is equal to a sum of X and Y. For example, C1=C2=C3>C4=C5=C6. The doping concentrations C1, C2, and C3 range from 4.5 × 10¹⁹ to 5.5 × 10¹⁹ per cubic centimeter; and the doping concentrations C4, C5, and C6 range from 0.5 × 10¹⁸ to 1.5 × 10¹⁸ per cubic centimeter.

FIG. 8 is a simulation diagram of a bandwidth of an LED undergoing doping in a third example according to an embodiment of this application. As shown in FIG. 8, at a low current density of 500 A/cm², a 3 dB modulation bandwidth of the LED undergoing doping in the third example is 1.46 GHz. Compared with the modulation bandwidth of the LED in FIG. 5, this modulation bandwidth is increased by 0.62 GHz.

In a fourth example, doping concentrations of X barrier layers that are among the M barrier layers and that are close to the N-type semiconductor layer 103 are the same. Doping concentrations of Y barrier layers that are among the M barrier layers and that are close to the P-type semiconductor layer 101 are the same. Doping concentrations of other Z barrier layers among the M barrier layers are the same. The doping concentrations of the barrier layers of the X barrier layers are greater than the doping concentrations of the barrier layers of the Z barrier layers. The doping concentrations of the barrier layers of the Z barrier layers are greater than the doping concentrations of the barrier layers of the Y barrier layers. M is equal to a sum of X, Y, and Z. For example, C1=C2>C3=C4>C5=C6. The doping concentrations C1 and C2 range from 4.5 × 10¹⁹ to 5.5 × 10¹⁹ per cubic centimeter; the doping concentrations C3 and C4 range from 0.5 × 10¹⁹ to 1.5 × 10¹⁹ per cubic centimeter; and the doping concentrations C5 and C6 range from 4.5 × 10¹⁸ to 5.5 × 10¹⁸ per cubic centimeter.

It can be learned from the foregoing descriptions of FIG. 2 that, the bandwidth of the LED can be increased by performing P-type doping on the barrier layer in the active region. In actual application, there are preferred ranges for a highest doping concentration and a lowest doping concentration, the highest doping concentration among the doping concentrations of the M barrier layers preferably ranges from 1 × 10¹⁸ to 1 × 10²⁰ per cubic centimeter, and the lowest doping concentration among the doping concentrations of the M barrier layers preferably ranges from 1 × 10¹⁶ to 1 × 10¹⁸ per cubic centimeter.

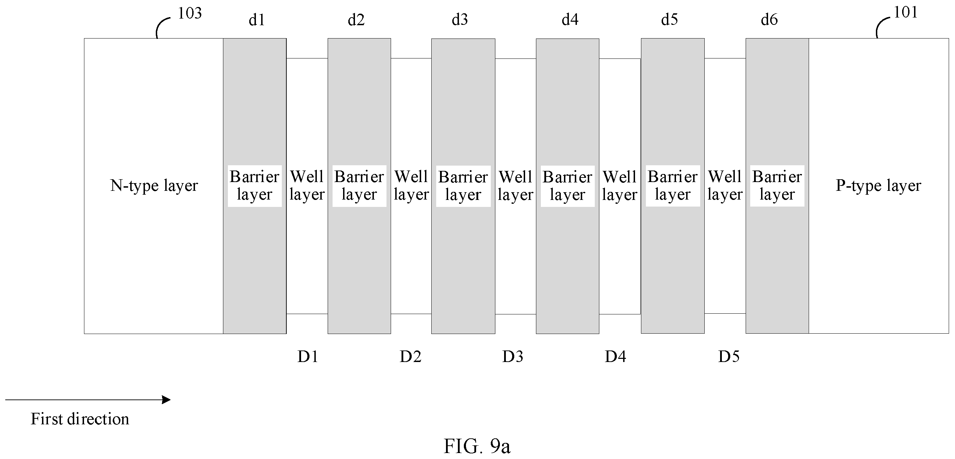

In actual application, the thicknesses of a well layer and the barrier layer in the active layer also affect a carrier density, carrier transport, and carrier match. As a result, the bandwidth of the LED is affected. The active layer of the LED includes M barrier layers and M-1 well layers, and a sum of the thicknesses of K first well layers and K first barrier layers that are among all the barrier layers and the well layers and that are close to the N-type semiconductor layer 103 is greater than a sum of the thicknesses of K second barrier layers and K second well layers that are close to the P-type semiconductor layer 101. When M is an even number, K=M/2-1; or when M is an odd number, K=M/2-1/2. FIG. 9a is a diagram of a fourth structure of an LED according to an embodiment of this application. In this embodiment of this application, an example in which M=6 is used for description. As shown in FIG. 9a, the LED includes an N-type layer 103, a P-type layer 101, and an active layer located between the N-type layer 103 and the P-type layer 101. The active layer includes six barrier layers and five well layers. The thicknesses of the six barrier layers are respectively d1, d2, d3, d4, d5, and d6. The thicknesses of the five well layers are respectively D1, D2, D3, D4, and D5. The thickness of the well layer or the barrier layer is a length of the well layer or the barrier layer in a first direction. The first direction is a light emitting direction or a reverse light emitting direction of the LED. In an example of FIG. 9a, d1+d2+d3+D1+D2>d4+d5+d6+D4+D5. This application provides several different distribution designs of the thicknesses of the well layer and the barrier layer. The following separately describes the designs by using an example in which M is equal to 6.

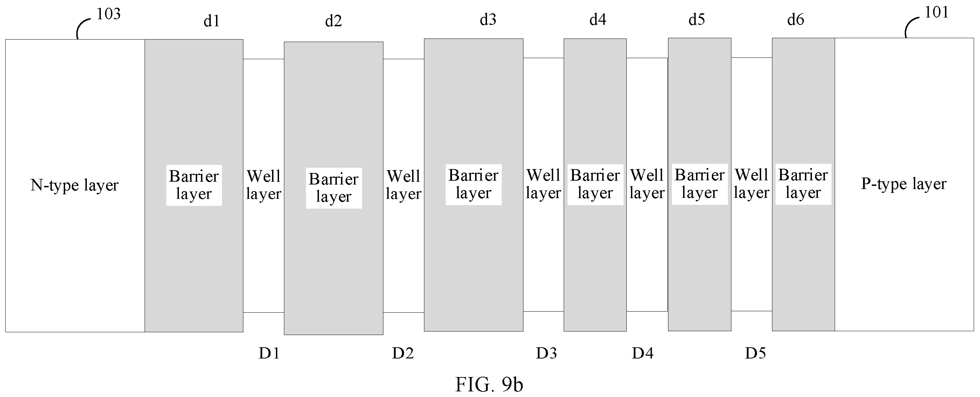

In a first manner, the thicknesses of the M-1 well layers are the same, and the thicknesses of the M barrier layers are different. In this case, D1=D2=D3=D4=D5. That the thicknesses of the M barrier layers are different means that there are barrier layers with different thicknesses among the M barrier layers. For example, d1>d2>d3>d4>d5>d6. The M barrier layers may include barrier layers with a same thickness. For example, d1=d2>d3>d4>d5>d6. In actual application, to improve hole injection and transport, the thickness of a barrier layer close to the P side may be reduced. The thicknesses of K first barrier layers are the same, the thicknesses of K second barrier layers are the same, and the thickness of the first barrier layer is greater than the thickness of the second barrier layer. In this case, d1=d2=d3>d4=d5=d6. FIG. 9b is a diagram of a fifth structure of an LED according to an embodiment of this application. As shown in FIG. 9b, D1=D2=D3=D4=D5, and d1=d2=d3>d4=d5=d6. For example, D1 is equal to 2 nanometers. A P-type layer 101 includes a P-ALGaN EBL electron blocking layer 901 and a P-GaN layer 902. It should be understood that, in actual application, the P-type layer 101 may further include a P⁺-GaN contact layer. The P-GaN layer 902 is located between the P-ALGaN EBL electron blocking layer 901 and the P⁺-GaN contact layer.

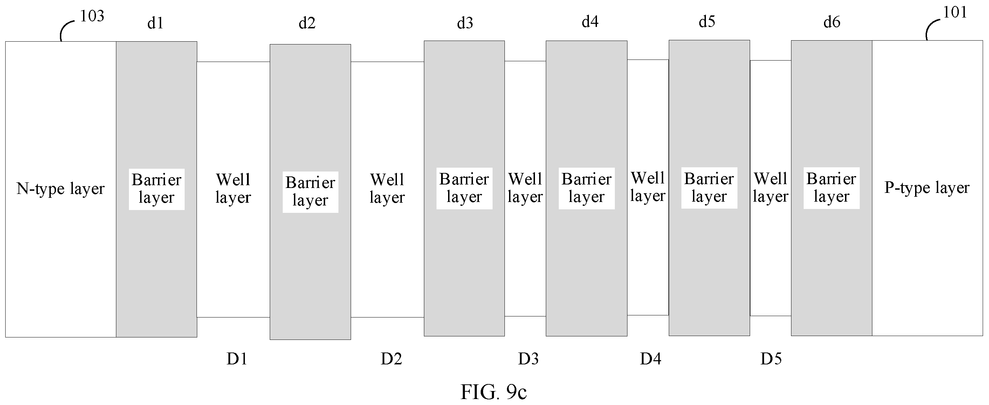

In a second manner, the thicknesses of the M barrier layers are the same, and the thicknesses of the M-1 well layers are different. In this case, d1=d2=d3=d4=d5=d6. That the thicknesses of the M-1 well layers are different means that there are well layers with different thicknesses among the M-1 well layers. For example, D1>D2>D3>D4>D5. The M-1 well layers may include well layers with a same thickness. For example, D1=D2>D3>D4>D5. In actual application, to increase a carrier density in a quantum well close to the P side and enhance spatial overlap between electron and hole wave functions, the thickness of the well layer can be reduced. The M-1 well layers include X-1 first well layers and Y second well layers. M is equal to a sum of X and Y. The thicknesses of the X-1 first well layers are the same. The thicknesses of the Y second well layers are the same. The thickness of the first well layer is greater than the thickness of the second well layer. For example, D1=D2>D3=D4=D5. FIG. 9c is a diagram of a sixth structure of an LED according to an embodiment of this application. As shown in FIG. 9c, d1=d2=d3=d4=d5=d6, and D1=D2>D3=D4=D5. For example, D1 is equal to 3 nanometers, and D3 is equal to 1.5 nanometers.

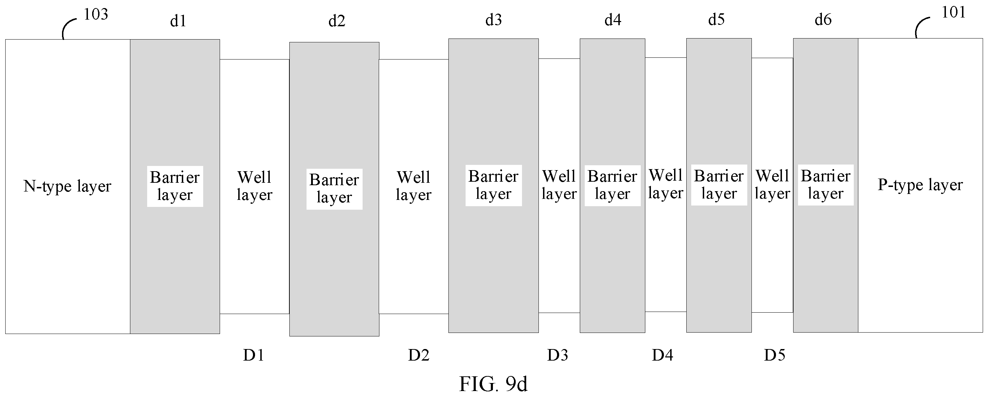

In a third manner, the thicknesses of the M barrier layers are different, and the thicknesses of the M-1 well layers are different. The thicknesses of K first barrier layers are the same. The thicknesses of K second barrier layers are the same. The thickness of the first barrier layer is greater than the thickness of the second barrier layer. The thicknesses of first well layers between the K first barrier layers are the same. The thicknesses of second well layers between the K second barrier layers are the same. The thickness of the first well layer is greater than the thickness of the second well layer. In this case, d1=d2=d3>d4=d5=d6, and D1=D2>D4=D5. FIG. 9d is a diagram of a seventh structure of an LED according to an embodiment of this application. As shown in FIG. 9d, d1=d2=d3>d4=d5=d6, and D1=D2>D3=D4=D5. In such design, a barrier layer close to the P side is thinner, and hole injection and transport are better. In addition, a well layer close to the P side is thinner, a carrier density in a quantum well is higher, and electron and hole wave functions overlap more in space. This helps improve radiative recombination efficiency and a modulation rate of the LED.

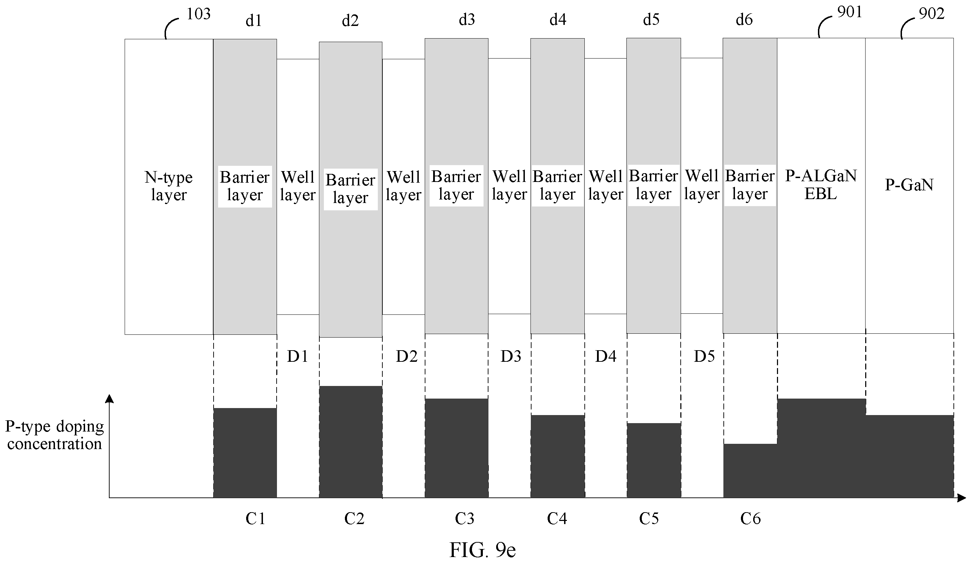

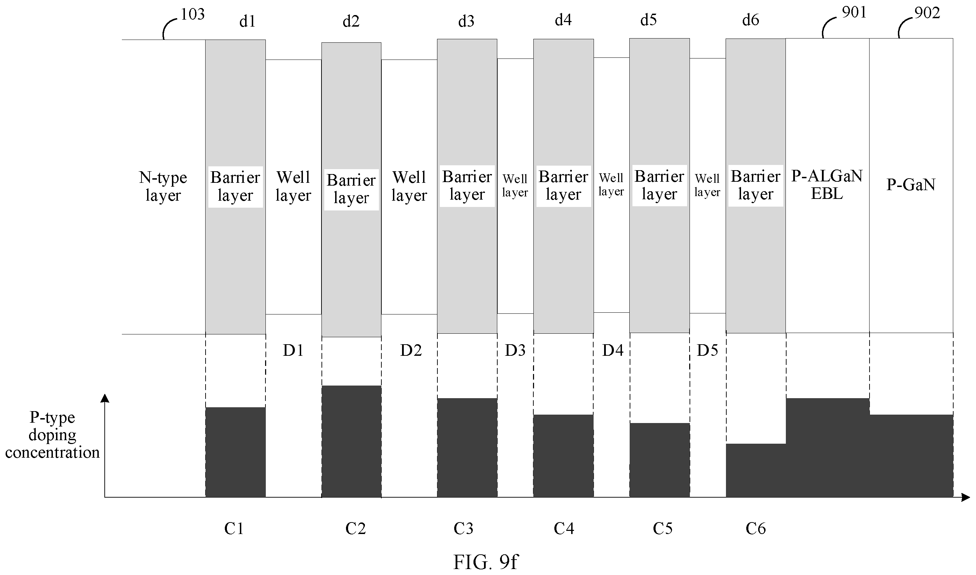

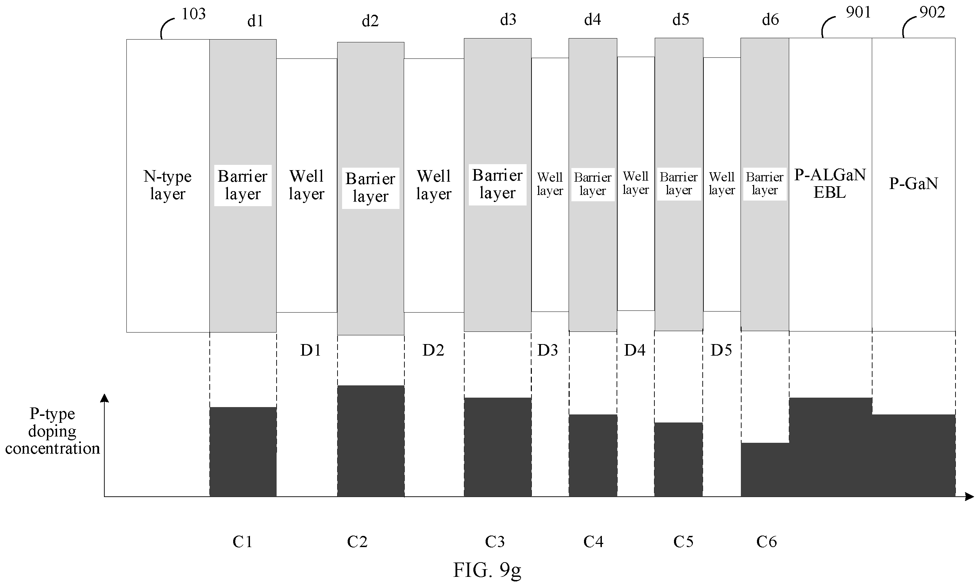

It should be understood that, in this embodiment of this application, both the P-type doping concentration of the barrier layer of the LED and the thicknesses of the well layer and the barrier layer in the active layer can be controlled, to increase the bandwidth of the LED. For example, FIG. 9e is a diagram of an eighth structure of an LED according to an embodiment of this application. In the LED in FIG. 9e, D1=D2=D3=D4=D5, d1=d2=d3>d4=d5=d6, and C1<C2>C3>C4>C5>C6. For another example, FIG. 9f is a diagram of a ninth structure of an LED according to an embodiment of this application. In the LED in FIG. 9f, d1=d2=d3=d4=d5=d6, D1=D2>D3=D4=D5, and C1<C2>C3>C4>C5>C6. For another example, FIG. 9g is a diagram of a tenth structure of an LED according to an embodiment of this application. In the LED in FIG. 9g, d1=d2=d3>d4=d5=d6, D1=D2>D3=D4=D5, and C1<C2>C3>C4>C5>C6. It should be understood that FIG. 9e to FIG. 9g merely show several examples provided in this embodiment of this application. In actual application, for the doping concentration of the barrier layer, refer to descriptions in any one of FIG. 4 to FIG. 8.

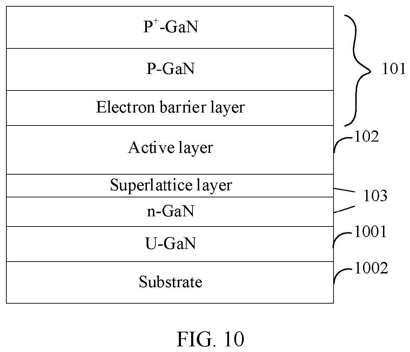

FIG. 10 is a diagram of a structure of an epitaxial wafer according to an embodiment of this application. As shown in FIG. 10, the epitaxial wafer includes a substrate 1002, an undoped U-GaN layer 1001, an N-type semiconductor layer 103, an active layer 102, and a P-type semiconductor layer 101. The P-type semiconductor layer 101 includes a P-type electron blocking layer, a P-GaN layer, and a P⁺-GaN contact layer. The N-type semiconductor layer 103 includes an n-GaN layer and a superlattice layer. An LED of a flip structure can be fabricated by bonding the epitaxial wafer to other chips and removing the substrate 1002 and the U-GaN layer.

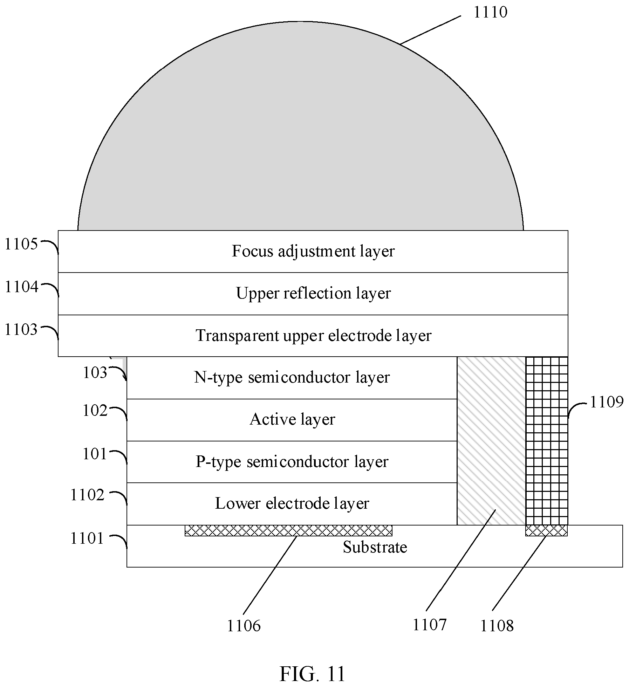

FIG. 11 is a diagram of an eleventh structure of an LED according to an embodiment of this application. As shown in FIG. 11, based on FIG. 1a, the LED sequentially includes a substrate 1101, a lower electrode layer 1102, a P-type semiconductor layer 101, an active layer 102, an N-type semiconductor layer 103, a transparent upper electrode layer 1103, an upper reflection layer 1104, and a focus adjustment layer 1105 in a first direction. The substrate 1101 can be made of silicon, an integrated circuit chip, a silicon interposer, an organic substrate, a glass substrate, a sapphire substrate, or the like. The substrate 1101 is configured to serve as a base and provide a processing circuit and a control circuit. The lower electrode layer 1102 is located between the substrate 1101 and the P-type semiconductor layer 101. The lower electrode layer 1102 can be made of metal. The P-type semiconductor layer 101 is located between the lower electrode layer 1102 and the active layer 102. The P-type semiconductor layer 101 can be made of GaN or the like. The active layer 102 is located between the P-type semiconductor layer 101 and the N-type semiconductor layer 103. The P-type semiconductor layer 101 is configured to provide hole carriers, and the N-type semiconductor layer 103 is configured to provide electron carriers. The active layer 102 may be a quantum well including gallium nitride (GaN) and indium gallium nitride (InGaN). The active layer 102 is configured to perform radiation recombination based on the hole carrier and the electron carrier. The N-type semiconductor layer 103 is located between the active layer 102 and the transparent upper electrode layer 1103. The N-type semiconductor layer 103 can be made of GaN or the like. The transparent upper electrode layer 1103 is located between the N-type semiconductor layer 103 and the upper reflection layer 1104. The transparent upper electrode layer 1103 may be a transparent conductive thin film. The transparent upper electrode layer 1103 can be made of indium tin oxide, aluminum zinc oxide, or the like. A transmittance of the transparent upper electrode layer 1103 is greater than 0%. For example, in actual application, a transmittance of the transparent upper electrode layer 1103 for visible light is greater than 30%, 50%, 70%, or 90%. The upper reflection layer 1104 may be a distributed Bragg reflection (distributed Bragg reflection, DBR) reflection layer. The upper reflection layer 1104 can be made of silicon dioxide, titanium dioxide, aluminum trioxide, tantalum pentoxide, or a combination thereof. The upper reflection layer 1104 is configured to reflect photons. The focus adjustment layer 1105 is also referred to as a spacer layer. The focus adjustment layer 1105 can be made of an insulation adhesive. A lens 1110 is disposed at the focus adjustment layer 1105 of the LED. The lens 1110 is configured to adjust a divergence angle of an optical signal output by the LED, to improve coupling efficiency of coupling the optical signal into an optical fiber or a waveguide.

The LED further includes an isolation layer 1107 and a connection electrode 1109. A first electrode 1106 and a second electrode 1108 are disposed on the substrate 1101. The isolation layer 1107 can be made of an insulation adhesive. The isolation layer 1107 can be further made of silicon dioxide, silicon nitride, or the like. The isolation layer 1107 is configured to isolate the connection electrode 1109 from the lower electrode layer 1102, the P-type semiconductor layer 101, the active layer 102, and the N-type semiconductor layer 103, and the connection electrode 1109 is configured to connect the transparent upper electrode layer 1103 to the second electrode 1108. The lower electrode layer 1102 is configured to be connected to the first electrode 1106. In the example of FIG. 1a, the LED supplies power to the transparent upper electrode layer 1103 through the second electrode 1108 on the substrate 1101, and supplies power to the lower electrode layer 1102 through the first electrode 1106 on the substrate 1101.

It should be understood that FIG. 11 merely shows an example of the LED provided in this embodiment of this application. In actual application, a person skilled in the art can adaptively modify the structure of the LED based on a requirement. For example, in FIG. 11, positions of the P-type semiconductor layer 101 and the N-type semiconductor layer 103 are exchanged. In this case, the P-type semiconductor layer 101 is located between the active layer 102 and the transparent upper electrode layer 1103, and the N-type semiconductor layer 103 is located between the active layer 102 and the lower electrode layer 1102. For another example, the lower electrode layer 1102 includes a lower reflection layer and a bonding metal layer. The lower reflection layer is located between the bonding metal layer and the P-type semiconductor layer 101. The bonding metal layer is between the substrate 1101 and the lower reflection layer.

In this embodiment of this application, the LED may be a micro light emitting diode (Micro-LED) or a resonant cavity micro light emitting diode (Resonant cavity micro light emitting diode, RC Micro-LED). For example, the length of the P-type semiconductor layer 101 can be less than 100 micrometers. The length of the P-type semiconductor layer 101 may also be referred to as the transverse size of the P-type semiconductor layer 101 or the mesa size of the LED. When FIG. 11 is a side view of the LED, the length of the P-type semiconductor layer 101 is a maximum size of the P-type semiconductor layer 101 in a top view of the LED. For example, when a shape of the P-type semiconductor layer 101 in the top view is a circle, the length of the P-type semiconductor layer 101 is a diameter of the P-type semiconductor layer 101.

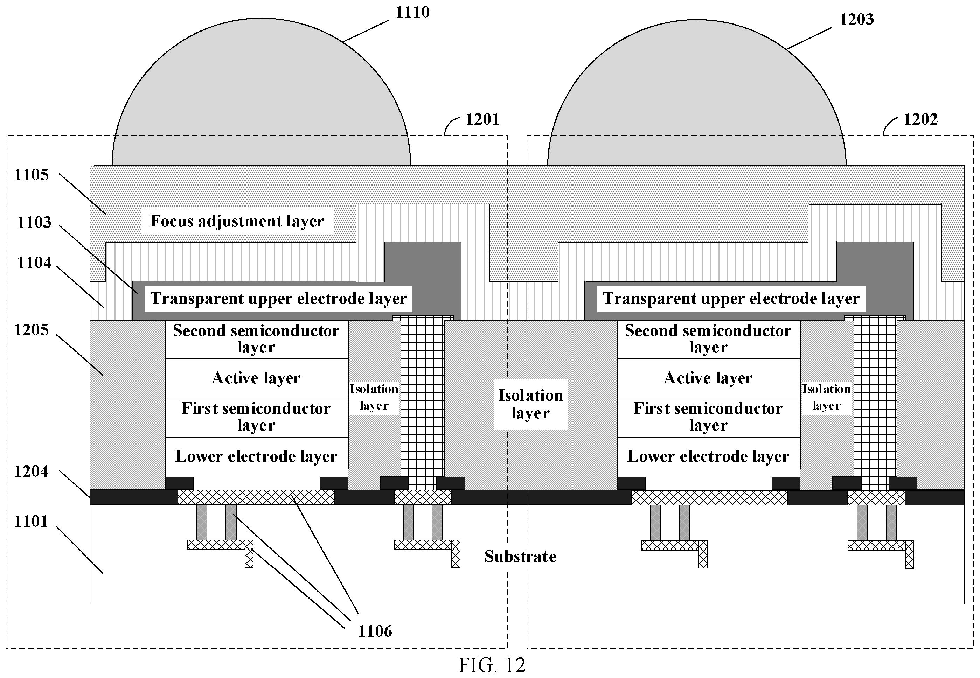

An embodiment of this application further provides an LED array. The LED array includes another LED and the LED described in FIG. 1a, FIG. 1b, FIG. 4, FIG. 9a to FIG. 9g, or FIG. 11. For a structure of the another LED in the LED array, refer to the LED in FIG. 1a, FIG. 1b, FIG. 4, FIG. 9a to FIG. 9g, or FIG. 11. The another LED and the LED share a same substrate. FIG. 12 is a diagram of a structure of an LED array according to an embodiment of this application. As shown in FIG. 12, the LED array includes two LEDs: an LED 1201 and an LED 1202 respectively. Based on FIG. 11, the LED 1201 further includes an insulation layer 1204 and a planarization layer 1205. The planarization layer 1205 is configured to fill a region between the substrate 1101 and the transparent upper electrode layer 1103. A part of the planarization layer 1205 can be used as an isolation layer. For descriptions of the LED 1202, refer to the descriptions of the LED 1201. The LED 1202 and the LED 1201 share the substrate 1101. In an example of FIG. 12, the LED 1202 and the LED 1201 further share the upper reflection layer 1104 and the focus adjustment layer 1105. A lens 1203 is disposed on the LED 1202. For descriptions of the lens 1203, refer to the descriptions of the lens 1110. It should be understood that a quantity of LEDs in the LED array is not limited to 2. Based on an application requirement, there may be dozens, hundreds, thousands, or more LEDs.

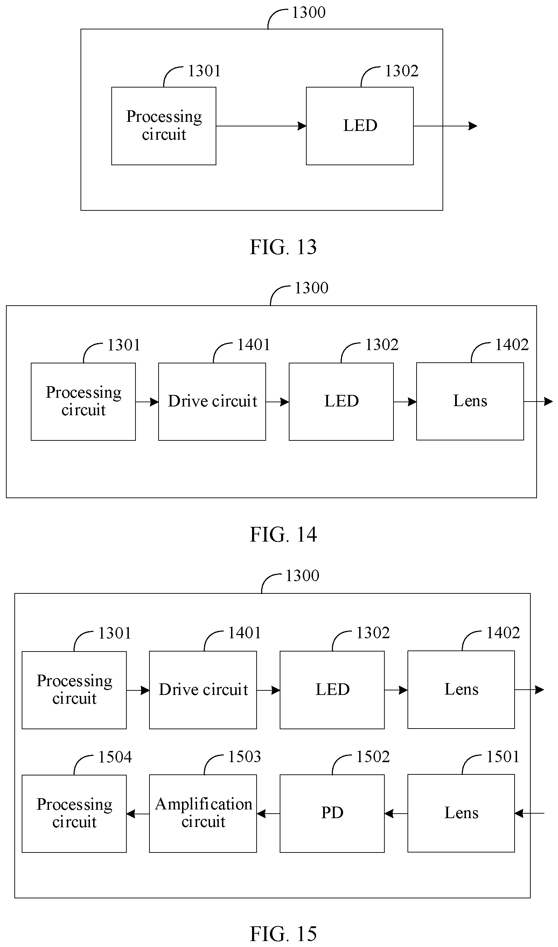

An embodiment of this application further provides an optical communication apparatus. FIG. 13 is a diagram of a first structure of an optical communication apparatus according to an embodiment of this application. As shown in FIG. 13, the optical communication apparatus 1300 includes a processing circuit 1301 and an LED 1302. The optical communication apparatus 1300 may also be referred to as an optical transmit module, an optical transceiver module, an optical module, an optical transmit device, an optical transmit end, an optical communication device, an optical interconnection transceiver apparatus, or the like. The processing circuit 1301 may also be referred to as a logic circuit. The processing circuit 1301 may be a processor. For example, the processing circuit 1301 may be a central processing unit (central processing unit, CPU), a graphics processing unit (graphics processing unit, GPU), a neural network processing unit (neural network processing unit, NPU), a network processor (network processor, NP), or a combination of the CPU and the NP. The processing circuit 1301 may further include a hardware chip or another general-purpose processor. The foregoing hardware chip may be an application-specific integrated circuit (application-specific integrated circuit, ASIC), a programmable logic device (programmable logic device, PLD), or a combination thereof. The processing circuit 1301 is configured to transmit an electrical signal to the LED 1302. The LED 1302 is configured to generate an optical signal based on the electrical signal. For descriptions of the LED 1302, refer to the descriptions of any one of FIG. 1a, FIG. 1b, FIG. 4, FIG. 9a to FIG. 9g, or FIG. 11.

In actual application, the optical communication apparatus 1300 can include the processing circuit 1301 and an LED array. For descriptions of the LED array, refer to the foregoing descriptions of FIG. 12. The processing circuit 1301 is configured to transmit a plurality of electrical signals to the LED array. The LED array includes a plurality of LEDs. The plurality of LEDs are in one-to-one correspondence with the plurality of electrical signals. The plurality of LEDs are configured to obtain a plurality of optical signals based on the plurality of electrical signals. The plurality of optical signals are in one-to-one correspondence with the plurality of LEDs.

FIG. 14 is a diagram of a second structure of an optical communication apparatus according to an embodiment of this application. As shown in FIG. 14, based on FIG. 13, the optical communication apparatus 1300 further includes a drive circuit 1401 and a lens 1402. The drive circuit 1401 is configured to receive the electrical signal from the processing circuit 1301, and obtain a drive electrical signal based on the electrical signal. The drive circuit 1401 is further configured to transmit the drive electrical signal to the LED 1302. The LED 1302 is configured to generate an optical signal based on the drive electrical signal, and output the optical signal through the lens 1402. For a position relationship between the lens 1402 and the LED 1302, refer to the descriptions in FIG. 11.

FIG. 15 is a diagram of a third structure of an optical communication apparatus according to an embodiment of this application. As shown in FIG. 15, based on FIG. 14, the optical communication apparatus 1300 further includes a lens 1501, a PD 1502, an amplification circuit 1503, and a processing circuit 1504. The lens 1501 is configured to receive another optical signal, adjust a divergence angle of the another optical signal, and focus the another optical signal to the PD 1502. The PD 1502 is configured to convert the another optical signal into another electrical signal, and transmit the electrical signal to the amplification circuit 1503. The amplification circuit 1503 can include a trans-impedance amplifier (trans-impedance amplifier, TIA) and a limiting amplifier (limiting amplifier, LA). The amplification circuit 1503 is configured to amplify the another electrical signal, and transmit an amplified electrical signal to the processing circuit 1504. The processing circuit 1504 and the processing circuit 1301 may be a same processor. The processing circuit 1504 is configured to process the amplified electrical signal. In actual application, to reduce costs of the optical communication apparatus 1300 or improve integration of the optical communication apparatus, the PD 1502 and the LED 1302 may be integrated on one substrate. In this case, the PD 1502 and the LED 1302 share the same substrate. The lens 1402, the LED 1302, the drive circuit 1401, the lens 1501, the PD 1502, and the amplification circuit 1503 may be integrated on a same substrate. In this case, the lens 1402, the LED 1302, the drive circuit 1401, the lens 1501, the PD 1502, and the amplification circuit 1503 share the same substrate. The lens 1402, the LED 1302, the drive circuit 1401, the processing circuit 1301, the lens 1501, the PD 1502, the amplification circuit 1503, and the processing circuit 1504 may be integrated on a same substrate. In this case, the lens 1402, the LED 1302, the drive circuit 1401, the processing circuit 1301, the lens 1501, the PD 1502, the amplification circuit 1503, and the processing circuit 1504 share the same substrate.

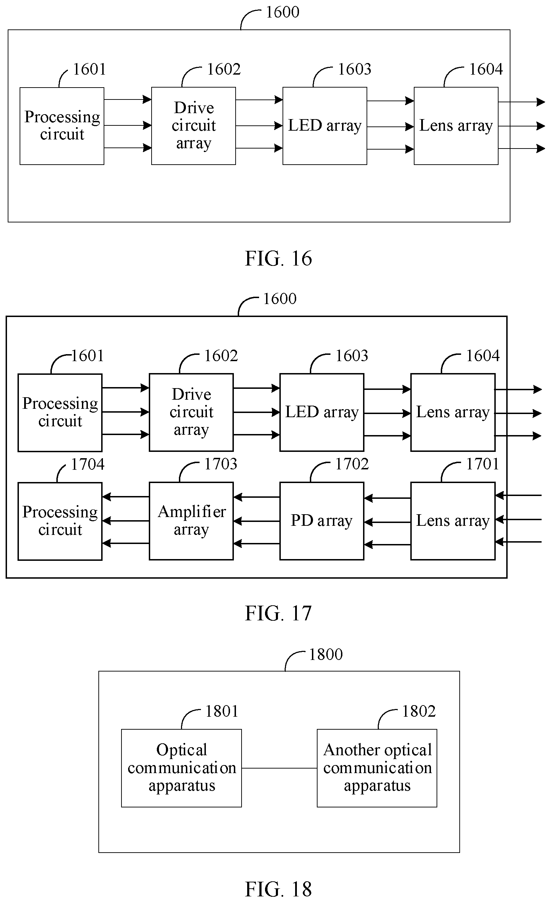

FIG. 16 is a diagram of a fourth structure of an optical communication apparatus according to an embodiment of this application. As shown in FIG. 16, the optical communication apparatus 1600 includes a processing circuit 1601, a plurality of drive circuits 1602, an LED array 1603, and a lens array 1604. For descriptions of the processing circuit 1601, refer to the descriptions of the processing circuit 1301 in FIG. 13. The processing circuit 1601 is configured to generate a plurality of electrical signals. The plurality of drive circuits 1602 are configured to generate a plurality of drive electrical signals based on the plurality of electrical signals. The plurality of drive circuits 1602 are in one-to-one correspondence with the plurality of drive electrical signals. The plurality of drive electrical signals are in one-to-one correspondence with the plurality of electrical signals. The LED array 1603 includes a plurality of LEDs. The plurality of LEDs are configured to generate a plurality of optical signals based on the plurality of drive electrical signals. The plurality of LEDs are in one-to-one correspondence with the plurality of optical signals. The plurality of drive electrical signals are in one-to-one correspondence with the plurality of optical signals. The lens array 1604 includes a plurality of lenses. The plurality of lenses are configured to adjust divergence angles of the plurality of optical signals. The plurality of lenses are in one-to-one correspondence with the plurality of optical signals.

FIG. 17 is a diagram of a fifth structure of an optical communication apparatus according to an embodiment of this application. As shown in FIG. 17, based on FIG. 16, the optical communication apparatus 1600 further includes a lens array 1701, a PD array 1702, an amplifier array 1703, and a processing circuit 1704. The lens array 1701 includes a plurality of lenses. The plurality of lenses are configured to receive a plurality of optical signals and focus the plurality of optical signals to a plurality of PDs of the PD array 1702. The plurality of optical signals are in one-to-one correspondence with the plurality of lenses. The plurality of optical signals are in one-to-one correspondence with the plurality of PDs. The plurality of PDs convert the plurality of optical signals into a plurality of electrical signals, and transmit the plurality of electrical signals to a plurality of amplification circuits in the amplifier array 1703. The plurality of electrical signals are in one-to-one correspondence with the plurality of PDs, and the plurality of electrical signals are in one-to-one correspondence with the plurality of amplification circuits. The plurality of amplification circuits are configured to amplify the plurality of electrical signals to obtain a plurality of amplified electrical signals, and transmit the plurality of amplified electrical signals to the processing circuit 1704. The plurality of amplified electrical signals are in one-to-one correspondence with the plurality of electrical signals. The processing circuit 1704 and the processing circuit 1601 may be a same processor.

FIG. 18 is a diagram of a structure of an optical communication system according to an embodiment of this application. As shown in FIG. 18, the optical communication system 1800 includes an optical communication apparatus 1801 and another optical communication apparatus 1802. The optical communication apparatus 1801 is connected to the another optical communication apparatus 1802 through an optical fiber or a waveguide. The optical fiber may be a single-mode optical fiber, a multi-mode optical fiber, an imaging optical fiber, a multi-core optical fiber, a light guiding optical fiber, a plastic optical fiber, or the like. The waveguide may be a flexible optical waveguide, a dielectric optical waveguide, or the like. The optical communication apparatus 1801 is configured to transmit one or more optical signals to the another optical communication apparatus 1802. For descriptions of the optical communication apparatus 1801, refer to the foregoing descriptions of the optical communication apparatus in any one of FIG. 13 to FIG. 17. When the optical communication apparatus 1801 is the optical communication apparatus in FIG. 13, FIG. 14, or FIG. 15, the optical communication apparatus 1801 is configured to transmit one optical signal to the another optical communication apparatus 1802. When the optical communication apparatus 1801 is the optical communication apparatus in FIG. 16 or FIG. 17, the optical communication apparatus 1801 is configured to transmit a plurality of optical signals to the another optical communication apparatus 1802. For descriptions of the another optical communication apparatus 1802, refer to the descriptions of the optical communication apparatus 1801.

The foregoing descriptions are merely specific implementations of this application, but are not intended to limit the protection scope of this application. Any variation or replacement readily figured out by a person skilled in the art within the technical scope disclosed in this application shall fall within the protection scope of this application.

## Claims

1. A light emitting diode LED, comprising a P-type semiconductor layer, an active layer, and an N-type semiconductor layer, wherein
the active layer is located between the P-type semiconductor layer and the N-type semiconductor layer, the active layer comprises M barrier layers and M-1 well layers, the barrier layers and the well layers are alternately distributed, M is an integer greater than 1, each of the M barrier layers is a P-type doped layer, a sum of doping concentrations of N first barrier layers that are among the M barrier layers and that are close to the N-type semiconductor layer is greater than a sum of doping concentrations of N second barrier layers that are among the M barrier layers and that are close to the P-type semiconductor layer, and when M is an even number, N=M/2; or when M is an odd number, N=M/2-1/2.

2. The LED according to claim 1, wherein a P-type edge barrier layer is a barrier layer that is among the M barrier layers and that is closest to the P-type semiconductor layer, an N-type edge barrier layer is a barrier layer that is among the M barrier layers and that is closest to the N-type semiconductor layer, a target barrier layer is a non-edge barrier layer among the M barrier layers, doping concentrations of barrier layers gradually increase from the N-type edge barrier layer to the target barrier layer, and doping concentrations of barrier layers gradually decrease from the target barrier layer to the P-type edge barrier layer.

3. The LED according to claim 2, wherein M is equal to 6, in a direction from the N-type semiconductor layer to the P-type semiconductor layer, doping concentrations of the M barrier layers are respectively C1, C2, C3, C4, C5, and C6, and C1<C2>C3>C4>C5>C6.

4. The LED according to claim 1, wherein in a direction from the N-type semiconductor layer to the P-type semiconductor layer, doping concentrations of the M barrier layers gradually decrease.

5. The LED according to claim 4, wherein M is equal to 6, in the direction from the N-type semiconductor layer to the P-type semiconductor layer, the doping concentrations of the M barrier layers are respectively C1, C2, C3, C4, C5, and C6, and C1>C2>C3>C4>C5>C6.

6. The LED according to claim 1, wherein doping concentrations of X barrier layers that are among the M barrier layers and that are close to the N-type semiconductor layer are the same, doping concentrations of Y barrier layers that are among the M barrier layers and that are close to the P-type semiconductor layer are the same, the doping concentrations of the X barrier layers are different from the doping concentrations of the Y barrier layers, and M is equal to a sum of X and Y.

7. The LED according to claim 6, wherein M is equal to 6, in a direction from the N-type semiconductor layer to the P-type semiconductor layer, doping concentrations of the M barrier layers are respectively C1, C2, C3, C4, C5, and C6, and C1=C2=C3>C4=C5=C6.

8. The LED according to claim 1, wherein doping concentrations of X barrier layers that are among the M barrier layers and that are close to the N-type semiconductor layer are the same, doping concentrations of Y barrier layers that are among the M barrier layers and that are close to the P-type semiconductor layer are the same, doping concentrations of Z barrier layers among the M barrier layers other than the X barrier layers and the Y barrier layers are the same, the doping concentrations of the barrier layers of the X barrier layers are greater than the doping concentrations of the Z barrier layers, the doping concentrations of the Z barrier layers are greater than the doping concentrations of the Y barrier layers, and M is equal to a sum of X, Y, and Z.

9. The LED according to claim 8, wherein M is equal to 6, in a direction from the N-type semiconductor layer to the P-type semiconductor layer, doping concentrations of the M barrier layers are respectively C1, C2, C3, C4, C5, and C6, and C1=C2>C3=C4>C5=C6.

10. The LED according to any one of claims 1 to 9, wherein a highest doping concentration among the doping concentrations of the M barrier layers ranges from 1 × 10¹⁸ to 1 × 10²¹ per cubic centimeter, and a lowest doping concentration among the doping concentrations of the M barrier layers ranges from 1 × 10¹⁶ to 1 × 10¹⁸ per cubic centimeter.

11. The LED according to any one of claims 1 to 10, wherein a sum of thicknesses of K first barrier layers and K first well layers that are among the M barrier layers and the M-1 well layers and that are close to the N-type semiconductor is greater than a sum of thicknesses of K second barrier layers and K second well layers that are close to the P-type semiconductor, and when M is an even number, K=M/2-1; or when M is an odd number, K=M/2-1/2.

12. The LED according to claim 11, wherein thicknesses of the M-1 well layers are the same, and thicknesses of the M barrier layers are different.

13. The LED according to claim 12, wherein the thicknesses of the K first barrier layers are the same, the thicknesses of the K second barrier layers are the same, and the thickness of the first barrier layer is greater than the thickness of the second barrier layer.

14. The LED according to claim 12, wherein the M barrier layers comprise X first barrier layers and Y second barrier layers, M is equal to a sum of X and Y, thicknesses of the X first barrier layers are the same, thicknesses of the Y second barrier layers are the same, and the thickness of the first barrier layer is greater than the thickness of the second barrier layer.

15. The LED according to claim 11, wherein thicknesses of the M barrier layers are the same, and thicknesses of the M-1 well layers are different.

16. The LED according to claim 15, wherein the thicknesses of the K first well layers are the same, the thicknesses of the K second well layers are the same, and the thickness of the first well layer is greater than the thickness of the second well layer.

17. The LED according to claim 15, wherein the M-1 well layers comprise X-1 first well layers and Y second well layers, M is equal to a sum of X and Y, thicknesses of the X-1 first well layers are the same, thicknesses of the Y second well layers are the same, and the thickness of the first well layer is greater than the thickness of the second well layer.

18. The LED according to claim 11, wherein thicknesses of the M barrier layers are different, and thicknesses of the M-1 well layers are different.

19. The LED according to claim 18, wherein the M barrier layers comprise X first barrier layers and Y second barrier layers, M is equal to a sum of X and Y, thicknesses of the X first barrier layers are the same, thicknesses of the Y second barrier layers are the same, and the thickness of the first barrier layer is greater than the thickness of the second barrier layer.

20. The LED according to claim 18, wherein the M-1 well layers comprise X-1 first well layers and Y second well layers, M is equal to a sum of X and Y, thicknesses of the X-1 first well layers are the same, thicknesses of the Y second well layers are the same, and the thickness of the first well layer is greater than the thickness of the second well layer.

21. A light emitting diode LED array, comprising another LED and the LED according to any one of claims 1 to 20, wherein the another LED and the LED share a same substrate.

22. An optical communication apparatus, comprising the light emitting diode LED according to any one of claims 1 to 20 or the LED array according to claim 21, and further comprising a processing circuit, wherein
the processing circuit is configured to transmit an electrical signal to the LED or the LED array; and
the LED or the LED array is configured to generate an optical signal based on the electrical signal.

23. The optical communication apparatus according to claim 22, wherein the optical communication apparatus further comprises an optical coupling structure, wherein
the optical coupling structure is configured to reduce a light emitting angle of the LED or the LED in the LED array.

24. The optical communication apparatus according to claim 22 or 23, wherein the optical communication apparatus further comprises a detector PD or a PD array, wherein
the PD or the PD array is configured to receive another optical signal, and convert the another optical signal into another electrical signal; and
the processing circuit is configured to receive the another electrical signal.

25. The optical communication apparatus according to claim 24, wherein the optical communication apparatus further comprises another optical coupling structure, wherein
the another optical coupling structure is configured to focus the another optical signal; and
the PD or the PD array is configured to convert the another focused optical signal into the another electrical signal.

26. An optical communication system, comprising another optical communication apparatus and the optical communication apparatus according to any one of claims 22 to 25, wherein
the optical communication apparatus is connected to the another optical communication apparatus through an optical fiber or an optical waveguide, and the optical communication apparatus is configured to transmit the optical signal to the another optical communication apparatus.
